Europäisches Patentamt

European Patent Office

Office européen des brevets

(19)

(11) Publication number: **0 269 205 B1**

(12) **EUROPEAN PATENT SPECIFICATION**

(45) Date of publication of patent specification: **02.05.91**  (51) Int. Cl.⁵: **H05K 9/00, E06B 5/18, E06B 3/12**

(21) Application number: **87307627.7**

(22) Date of filing: **28.08.87**

(54) A technique for connecting frame and panel members to produce an RF seal.

(30) Priority: **30.08.86 GB 8621033**

(43) Date of publication of application:
**01.06.88 Bulletin 88/22**

(45) Publication of the grant of the patent:
**02.05.91 Bulletin 91/18**

(84) Designated Contracting States:
**BE DE FR NL**

(56) References cited:
**FR-A- 1 377 913**
**US-A- 2 704 301**
**US-A- 3 147 336**
**US-A- 4 507 520**

(73) Proprietor: **THE MARCONI COMPANY LIMITED**
**The Grove Warren Lane**
**Stanmore Middlesex HA7 4LY(GB)**

(72) Inventor: **Henderson, William Iain Mackie**
**91 Edge Hill Darras Hall**
**Ponteland Northumberland NE20 9JQ(GB)**
Inventor: **Morrison, David John**
**5 Hobart Whitley Bay**
**Tyne & Wear NE26 3TA(GB)**

Inventor: **Smith, Moira**
**19 Foxhills Covert**
**Wickam Newcastle NE16 5TN(GB)**
Inventor: **Thornley, David John**
**4 Sunny Brae Ryton**
**Tyne & Wear NE40 4JB(GB)**
Inventor: **Leask, Samuel Hall**
**27 Walworth Avenue**
**Narsden Estate South Shields NE34 7EP(GB)**
Inventor: **Matthews, Christopher F.**
**Dere Hollow**
**Riding Hill Northumberland NE44 5DQ(GB)**

(74) Representative: **Hyden, Martin Douglas et al**
**GEC Patent Department GEC-Marconi Re-**
**search Centre West Hanningfield Road**
**Great Baddow Essex CM2 8HN(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to apparatus for providing a shield against electromagnetic interference.

Sensitive electrical equipment, especially that which generates or receives electromagnetic radiation often requires shielding from the interfering effects of radiation from external sources. The invention arose in the design of a shelter for portable electronic equipment. Such a shelter needs to be strong and lightweight, and to meet these requirements a construction was adopted employing a framework of extruded aluminium. The framework carries panels formed from an inner layer of rigid foam plastics material bonded to outer sheets of aluminium. In some parts of the shelter, in particular the door, a panel fits into a channel defined by extruded frame members. A problem was encountered in obtaining a sufficiently accurate fit between the inner surfaces of the channel and the panels to eliminate any leakage of electromagnetic interference.

The invention as claimed provides apparatus for providing a shield against electromagnetic interference comprising a frame of extruded frame members defining a channel, and a panel having an edge received by the channel, the edge having a slot extending along it and defining, on opposite sides of the slot, edge portions of the panel which can be pressed resiliently together for insertion of the edge of the panel into the channel.

By employing the invention it is possible to make the width of the channel exactly the same as, or smaller than, the width of the panel, thereby ensuring a very good fit which prevents leakage of electro-magnetic interference.

The construction is particularly suitable for the door of a shelter or other container but it could be used for the main structure of the latter.

The panel is preferably made from an inner layer of rigid foam plastics material laminated to outer layers of aluminium. It would however be possible to use other materials. For example, the inner layer could be of wood and the outer layers of any conductive metal. Also it would, at least in theory, be possible to have a conductive layer on just one surface, either the inside or the outside.

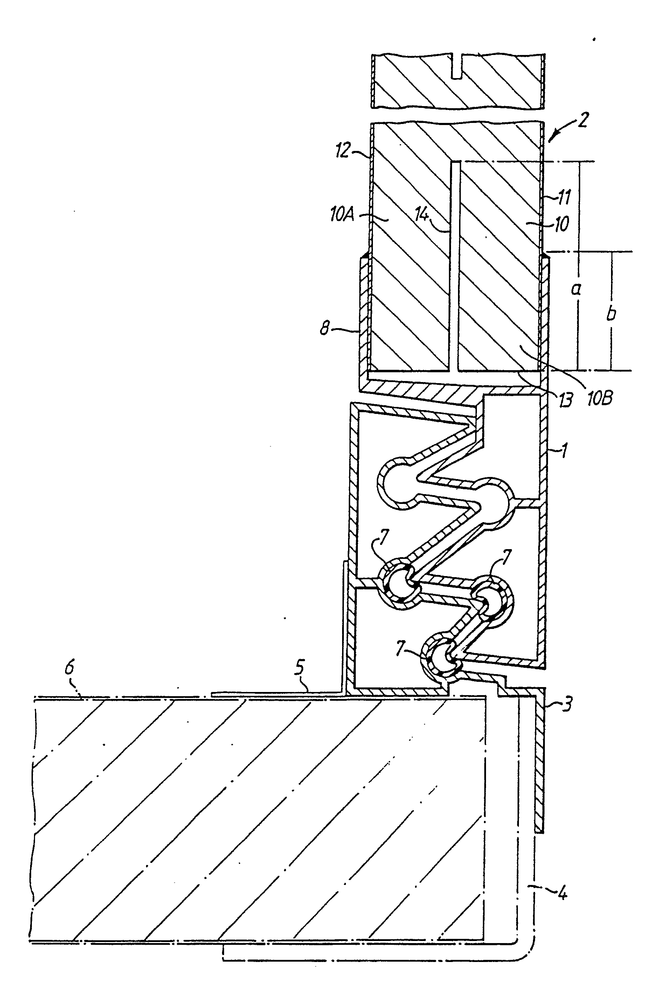

One manner in which the invention may be performed will now be described by way of example, with reference to the accompanying drawing, which is a vertical cross-section through a bottom edge of an electronic equipment shelter constructed in accordance with the invention showing the bottom of a door forming part of the shelter.

The door, shown in the drawing, has a frame formed from four extruded aluminium members of which only the bottom member 1 is shown. This frame supports a door panel 2 and the door fits in a door recess defined by extruded aluminium members of which only a bottom member 3 is illustrated. The member 3 is secured by brackets 4 and 5 to a floor 6 of the shelter.

The door frame member 2 and the door recess member 4 has corrugated faces which co-operate to form a seal against electro-magnetic interference. Sealing strips 7 are located in some of the valleys of the corrugations to improve the sealing effect.

The member 1 has flanges 8 and 9 defining a channel which receives the bottom edge of the door panel 2. The top and side edges of the door panel are received in similar channels defined by the top and side door frame members (not shown).

The panel 2 is formed from a layer 10 of rigid foamed synthetic plastics material bonded by adhesive to aluminium sheets 11 and 12. Each edge, such as the bottom edge 13, is formed with a slot 14 extending along it. The depth a of this slot is notably greater than the depth b into the channel that the edge 13 extends. The slot defines, on opposite sides of it, portions 10a, 10b which can, because of the resilient nature of the panel 10, bend inwardly so as to tend to close the slot. This allows insertion of the panel edge 13 into the channel during assembly of the door. The portions 10a, 10b subsequently tend to spring apart, pressing the conductive sheets 11 and 12 securely against and into electrical contact with the inner surfaces of the flanges 7 and 8 to form an effective seal against electromagnetic interference.

## Claims

1. Apparatus for providing a shield against electro-magnetic interference comprising a frame (1) of extruded frame members defining a channel; and a shielding panel (2) having an edge (13) received by the channel, characterised in that the edge (13) has a slot (14) extending along it and defining, on opposite sides of the slot, edge portions (10a, 10b) of the panel which can be pressed resiliently together for insertion of the edge of the panel into the channel.

2. A container comprising apparatus as claimed in claim 1 wherein the frame is a door frame and the panel is a door panel.

3. Apparatus according to claim 1 or 2 characterised in that the panel (2) has an inner layer (10A) of rigid synthetic plastics foam material and at least one outer layer (11, 12) of electrically conductive material.

## Revendications

1. Appareil destiné à fournir un blindage contre les interférences électromagnétiques comportant un châssis (1) en éléments de châssis extrudés définissant un profilé; et un panneau de blindage (2) ayant un bord (13) reçu dans le profilé, caractérisé en ce que le bord (13) a une fente (14) s'étendant dans le sens de la longueur et définissant, sur les côtés opposés à la fente, des parties de bord (10A, 10B) du panneau qui peuvent être pressées ensemble de manière élastique pour insertion du bord du panneau dans le profilé.

2. Conteneur comportant un appareil selon la revendication 1, dans lequel le châssis est un châssis de porte et le panneau est un panneau de porte.

3. Appareil selon la revendication 1 ou 2, caractérisé en ce que le panneau (2) possède une couche intérieure (10A) en mousse de matière plastique synthétique rigide et au moins une couche extérieure (11, 12) en matériau électriquement conducteur.

## Ansprüche

1. Vorrichtung zur Schaffung einer Abschirmung gegen elektromagnetische Störung, welche umfaßt einen Rahmen (1) aus extrudierten Rahmenelementen, die ein U-Profil bestimmen; und eine Schirmtafel (2) mit einer durch das U-Profil aufgenommenen Kante (13), dadurch gekennzeichnet, daß die Kante (13) einen sich in ihrer Längsrichtung erstreckenden Schlitz (14) besitzt, der an einander gegenüberliegenden Seiten des Schlitzes Kantenabschnitte (10A, 10B) der Tafel bestimmt, die zum Einsetzen der Tafel in das U-Profil elastisch zusammengedrückt werden können.

2. Die Vorrichtung nach Anspruch 1 umfassender Behälter, bei dem der Rahmen ein Türrahmen und die Tafel eine Türtafel ist.

3. Vorrichtung nach Anspruch 1 oder 2, dadurch gekennzeichnet, daß die Tafel (2) eine Innenschicht (10) aus starrem synthetischen Kunststoff-Schaummaterial und mindestens eine Außenschicht (11, 12) aus elektrisch leitendem Material besitzt.